# EUROPÄISCHE PATENTSCHRIFT

(11) **EP 3 044 024 B1**
(45) Veröffentlichungstag und Bekanntmachung des Hinweises auf die Patenterteilung: **29.03.2017**
(21) Anmeldenummer: 14766416.3
(22) Anmeldetag: 05.09.2014
(51) Int. Cl.: B60K 35/00, B60K 37/00, B60K 37/06, B60R 11/00, B60R 11/02, G05G 1/015, G05G 1/08, G05G 5/03, G06F 3/041, H01H 19/54

(54) **BILDSCHIRMBASIERTES FAHRZEUGBEDIENSYSTEM**
SCREEN-BASED VEHICLE OPERATING SYSTEM
SYSTÈME DE COMMANDE POUR UN VÉHICULE, BASÉ SUR UN ÉCRAN

(30) Priorität: 09.09.2013 DE 102013014792
(43) Veröffentlichungstag der Anmeldung: 20.07.2016
(73) Patentinhaber: Leopold Kostal GmbH & Co. KG, 58513 Lüdenscheid (DE)
(72) Erfinder: BLÄSING, Frank, 59457 Werl (DE); BÖBEL, Ralf, 59439 Holzwickede (DE)
(74) Vertreter: Kerkmann, Detlef
(86) Internationale Anmeldenummer: PCT/EP2014/068935
(87) Internationale Veröffentlichungsnummer: WO 2015/032891

(56) Entgegenhaltungen:
- EP-A1- 2 159 455
- EP-A2- 2 103 476
- EP-A2- 2 161 643
- WO-A1-2012/080128
- DE-A1-102008 041 649

## Beschreibung

Die vorliegende Erfindung betrifft ein bildschirmbasiertes Fahrzeugbediensystem mit einer zumindest einen Bildschirm sowie zumindest ein gegenüber einem feststehenden Gehäuse drehbeweglich gelagertes mechanisches Bedienelement umfassenden Bedieneinrichtung, wobei das mechanische Bedienelement derart angeordnet ist, dass es teilweise in das Anzeigefeld des Bildschirms hineinragt und dieses dort teilweise überdeckt.

Fahrzeugbediensysteme mit einem Bildschirm sind inzwischen in modernen Kraftfahrzeugen weit verbreitet. Sie dienen zur Steuerung des Fahrzeugs selbst und seiner Komponenten, sowie zur Steuerung von Zusatzgeräten wie z.B. Navigationssystemen, Multimedia-Entertainment-Systemen oder allgemein Fahrerassistenzsystemen insbesondere im Zusammenhang mit Kamera-Anwendungen. Als Eingabeelemente zur Bedienung dieser Geräte werden einerseits berührungsempfindliche Touch-Bildschirme andererseits aber auch durchaus herkömmliche Bedienelemente verwendet. Im Vergleich zu der Bedienung über Touch-Bildschirme bieten herkömmliche Bedienelemente insbesondere den Vorteil bei entsprechender Auslegung auch eine haptische Rückmeldung über die erfolgte Bedienung zu ermöglichen.

Die DE 10 2008 041 649 A1 zeigt ein bildschirmbasiertes Fahrzeugbediensystem gemäß dem Oberbegriff des Patentanspruchs 1. Dieses Fahrzeugbediensystem ist mit einem Bildschirm versehen, der zur Bildung einer Eingabeschnittstelle auch als berührungsempfindlicher Touch-Bildschirm ausgeführt sein kann. Als mechanische Bedienelemente sind bei diesem System Drehknöpfe vorgesehen, die derart angeordnet sind, dass sie teilweise in das Anzeigefeld des Bildschirms hineinragen und dieses dort teilweise überdecken.

Die vorliegende Erfindung zeigt eine konkrete Ausführung eines geeigneten mechanischen Bedienelements und seiner Zuordnung zu dem Bildschirm. Die erfindungsgemäße Ausführung gewährleistet eine stabile Lagerung des Bedienelements bei einer nur geringen Abdeckung der nutzbaren Anzeigefläche des Bildschirms.

Dies gelingt erfindungsgemäß dadurch, dass das mechanische Bedienelement als Drehring ausgeführt ist, der auf einem ersten Teil seines Umfangs in axialer Richtung in das Gehäuse eingelassen ist, und mit einem zweiten Teil seines Umfangs vollständig aus dem Gehäuse heraus ragt und sich mit diesem Teil zumindest abschnittsweise oberhalb der Oberfläche des Bildschirms erstreckt, so dass die Anzeigefläche des Bildschirms im "Inneren" des Drehrings für Anzeige- und/oder Bedienzwecke nutzbar ist.

In einer bevorzugten Ausführungsform des erfindungsgemäßen Fahrzeugbediensystems ist in dem Drehring eine mehrere Magnetpole ausbildende Anordnung von Permanentmagneten aufgenommen, die mit in dem Gehäuse angeordneten Magnetfelderzeugungsmitteln zur Bildung einer Rastvorrichtung kooperiert.

Ein besonders einfacher und robuster Aufbau ergibt sich, wenn die in dem Gehäuse angeordneten Magnetfelderzeugungsmittel ebenfalls durch eine mehrere Magnetpole ausbildende Anordnung von Permanentmagneten gebildet ist, die vorzugsweise in dem Gehäuse mit dem gleichen Rasterabstand, auf dem gleichen Kreisradius und in der gleichen Längsausrichtung und Polarität wie die Permanentmagneten in dem Drehring angeordnet sind.

In einer Weiterbildung dieser bevorzugten Ausführungsform ist vorgesehen, dass die Anordnung von Permanentmagneten in dem Drehring außerdem mit zumindest einem in dem Gehäuse angeordneten Magnetfeldsensor zur Erzeugung eines Ausgangssignals kooperiert.

Ein Ausführungsbeispiel der Erfindung ist in der Zeichnung dargestellt und wird im folgenden anhand der Zeichnung näher erläutert.

Es zeigen
- Fig. 1: eine Ansicht einer Bedieneinrichtung des erfindungsgemäßen Fahrzeugbediensystems
- Fig. 2: eine schematische Darstellung der Integration der Bedieneinrichtung aus Fig. 1 in einer Mittelkonsole eines Fahrzeugs
- Fig. 3: eine teilgeschnittene Ansicht des Drehrings und seines Lagers im Gehäuse, sowie die zugehörigen Magnetanordnungen
- Fig. 4: die Magnetanordnungen aus Fig. 3 einschließlich der dort verdeckten Hall-Sensoren

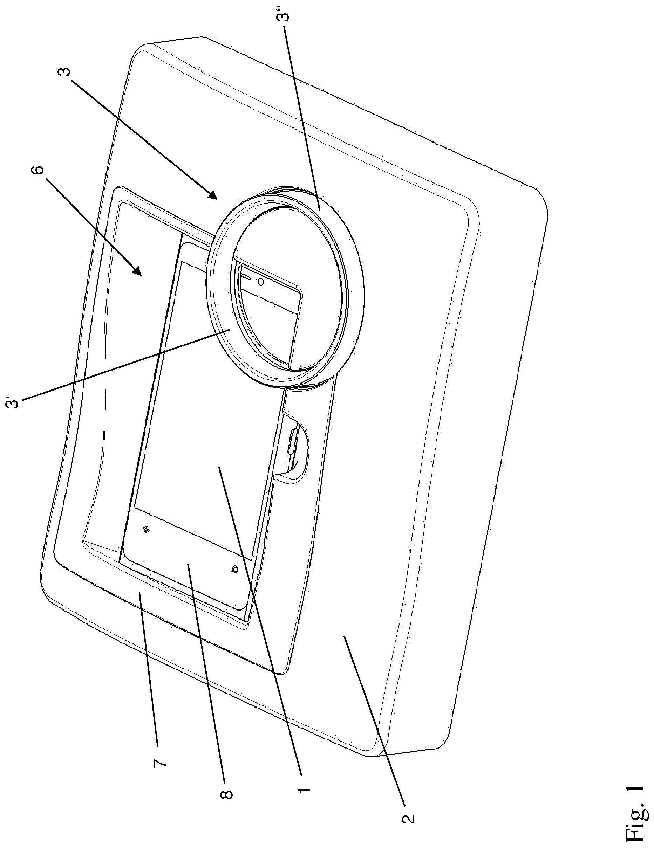

Die Fig. 1 zeigt eine Ausführungsform einer Bedieneinrichtung des erfindungsgemäßen bildschirmbasierten Fahrzeugbediensystems. Das Gehäuse 2 der Bedieneinrichtung weist eine Vertiefung 6 auf, die Bestandteil einer Aufnahmevorrichtung 7 für ein mobiles Gerät 8 mit einem Bildschirm ist. Das mobile Gerät 8 ist z.B. wie hier dargestellt ein Smartphone mit einem berührungsempfindlichen Touch-Bildschirm. Die Aufnahmevorrichtung 7 umfasst dabei eine als auswechselbares Teil des Gehäuses 2 ausgeführte, die Vertiefung 6 ausbildende Ablageschale. Zur Verwendung unterschiedlicher mobiler Geräte 8 können somit an diese jeweils elektrisch und mechanisch angepasste Aufnahmevorrichtungen 7 eingesetzt werden. Der einen funktionalen Bestandteil der Bedieneinrichtung des erfindungsgemäßen Fahrzeugbediensystems bildende Bildschirm 1 ist dabei physisch Bestandteil des mobilen Gerätes 8. Das mobile Gerät 8 ist mit der Bedieneinrichtung über eine hier nicht dargestellte Datenkommunikationsschnittstelle verbunden. Diese Schnittstelle kann beispielsweise als Steckverbindung ausgeführt sein, bevorzugt erfolgt die Verbindung aber drahtlos z.B. über WLAN oder Bluetooth. Außerdem ist das mobile Gerät 8 mit der Bedieneinrichtung über eine ebenfalls bevorzugt drahtlose Energieübertragungsschnittstelle verbunden, über die der interne Akku des mobilen Geräts 8 induktiv geladen werden kann.

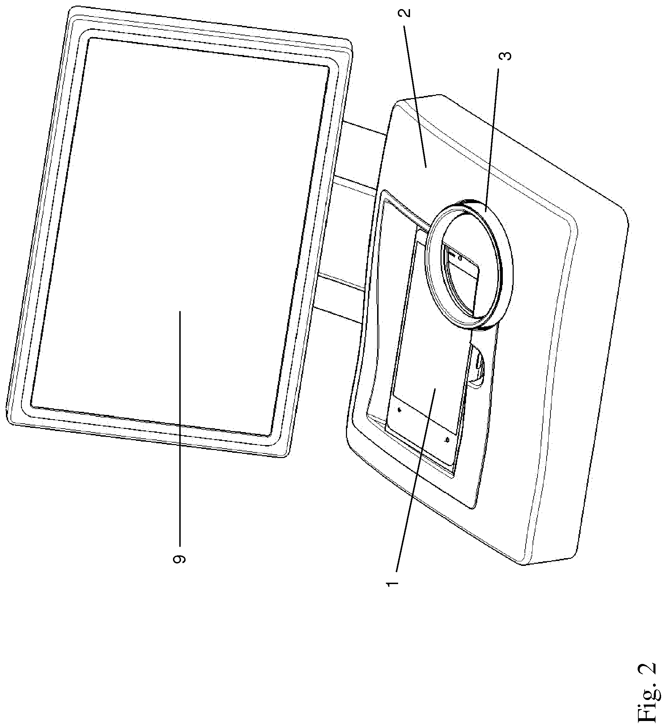

Das Gehäuse 2 der Bedieneinrichtung ist, wie in Fig. 2 schematisch dargestellt, Teil des unteren, im Wesentlichen horizontalen Abschnitts der Mittelkonsole des Fahrzeugs. Der Bildschirm 1 des mobilen Geräts 8 dient in dem hier dargestellten Konzept zwar in erster Linie durch Ausnutzung seiner Touch-Funktion als Eingabeschnittstelle der Bedieneinrichtung, wobei aber auch insbesondere diese Funktion unterstützende Darstellungsmöglichkeiten des Bildschirms 1 ebenfalls genutzt werden. Zur hauptsächlichen Darstellung der die gesteuerten Fahrzeug- oder Zusatzgerätefunktionen betreffenden Inhalte ist ein weiterer, in der Regel größerer Bildschirm 9 im oberen, im wesentlichen senkrechten Teil der Mittelkonsole des Fahrzeugs vorhanden.

Zusätzlich zu der Touch-Funktion des Bildschirms 1 des mobilen Geräts 8 als Eingabeschnittstelle umfasst die Bedieneinrichtung ein gegenüber dem Gehäuse 2 drehbeweglich gelagertes mechanisches Bedienelement. Dieses mechanische Bedienelement ist als Drehring 3 ausgeführt, der in dem Gehäuse 2 so angeordnet ist, dass er teilweise in das Anzeigefeld des Bildschirms 1 hineinragt. Der Drehring 3 ist dazu auf einem ersten Teil 3' seines Umfangs, der etwa einen Dreiviertelkreis ausmacht, in axialer Richtung in das Gehäuse 2 eingelassen. Der Drehring 3 ist an seinem unteren Ende mit einem radial nach innen weisenden Kragen 3* versehen, der in Kooperation mit einer entsprechenden Nut 2* im Gehäuse 2 ein Gleitlager bildet. Mit einem zweiten Teil 3" seines Umfangs, also dem restlichen, annähernden Viertelkreis, ragt der Drehring 3 vollständig aus dem Gehäuse 2 heraus. Mit diesem Teil 3" seines Umfangs erstreckt sich der Drehring 3 im Bereich der Vertiefung 6, die Bestandteil der Aufnahmevorrichtung 7 für das mobile Gerät 8 ist, und somit auch zumindest abschnittsweise oberhalb der Oberfläche des Bildschirms 1 des dort eingesetzten Geräts 8. Die hier verwendete Bezeichnung der Teile 3' und 3" des Umfangs des Drehrings 3, die im Gehäuse 2 eingelassen sind bzw. vollständig aus diesem herausragen, ist selbstverständlich dynamisch zu verstehen, da sich diese beim Drehen desselben ständig ändern. Durch die Ausbildung des Bedienelements als Drehring 3 und nicht als Drehknopf wird ein wesentlich geringerer Anteil der Anzeigefläche des Bildschirms 1 verdeckt, wobei sich insbesondere durch die Nutzung der Anzeigefläche im "Inneren" des Drehrings interessante Darstellungs- und Bedienmöglichkeiten ergeben. So kann etwa eine Bestätigungstaste als Touch-Funktion auf dem Bildschirm quasi im Zentrum des Drehrings vorgesehen werden.

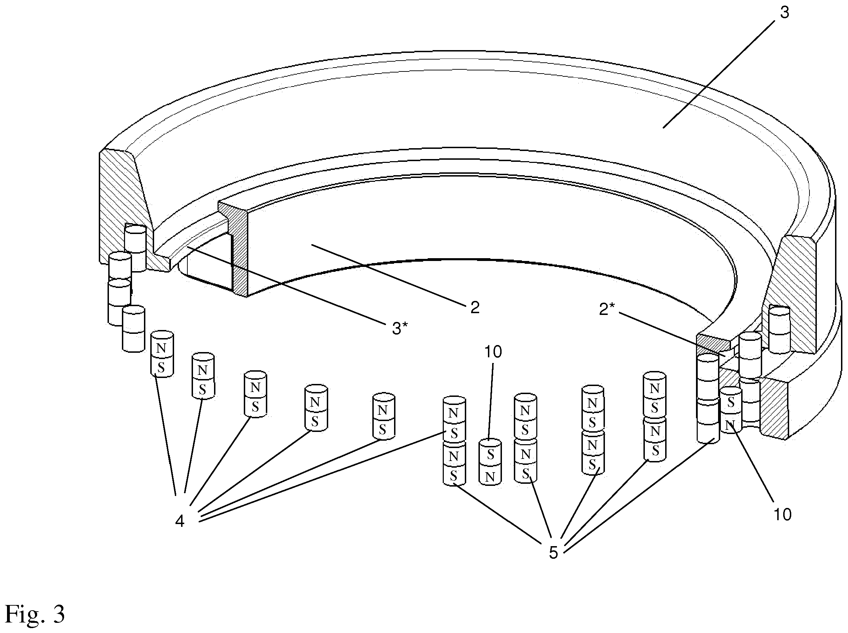

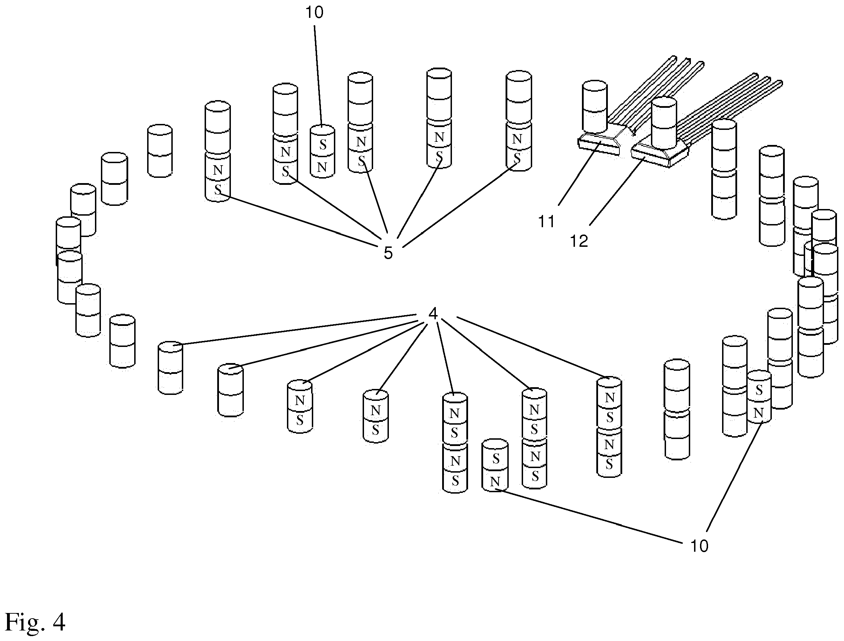

Zur Erzeugung einer mechanischen Rastung und somit einer haptischen Rückmeldung bei Betätigung des Drehrings 3 sind miteinander kooperierende Mittel zur Erzeugung magnetischer Felder in dem Drehring 3 und in der Aufnahmevorrichtung 7 vorhanden. In der hier dargestellten Ausführungsform sind, wie aus den Fig. 3 und 4 zu sehen, in dem Drehring 3 über dessen Umfang im Abstand der gewünschten Rastabstände verteilt Permanentmagnete 4 angeordnet. Diese Permanentmagnete 4 sind als Stabmagnete ausgeführt, die mit ihren Längsachsen axial, also parallel zu Drehachse des Drehrings 3 und alle mit gleicher Magnetisierungsrichtung - in diesem Falle mit ihren Südpolen nach unten weisend - ausgerichtet sind. Die in Kooperation mit diesen Magneten 4 zur Erzeugung der gewünschten Rastung vorgesehenen, gehäuseseitig als Teil der Aufnahmevorrichtung 7 vorhandenen Magnetfelderzeugungsmittel sind hier ebenfalls als stabförmige Permanentmagnete 5 ausgeführt. Diese sind in der hier gezeigten Ausführung im Gehäuse 2 mit dem gleichen Rasterabstand, auf dem gleichen Kreisradius und in der gleichen Längsausrichtung und Polarität wie diejenigen in dem Drehring 3 angeordnet, so dass sich in einer Raststellung, also in einem stabilen Gleichgewichtszustand, jeweils ein Südpol eines Magneten 4 im Drehring 3 und ein Nordpol eines Magneten 5 in der Aufnahmevorrichtung 7 gegenüber liegen. Die Anziehungskräfte zwischen diesen Magneten 4, 5 bewirken die Rastkraft. Grundsätzlich wäre ein einziger der Magnete 5 in der Aufnahmevorrichtung 7 ausreichend um eine solche Rastung zu erzeugen. Über die tatsächliche Anzahl der in der Aufnahmevorrichtung 7 eingesetzten Magnete 5, ihre Größe und Stärke sowie ihren axialen Abstand zu den Magneten 4 des Drehrings 3 lässt sich die Stärke der Rastkraft einstellen. Die Magnete 5 in der Aufnahmevorrichtung 7 können auch auf einem größeren oder kleineren Kreisradius als diejenigen in dem Drehring 3 angeordnet werden, wodurch ein weiterer Parameter zur Änderung der Stärke und des Verlaufs der Rastkraft gegeben ist.

Selbstverständlich können sowohl in dem Drehring 3 als auch in der Aufnahmevorrichtung 7 alternativ zu den dargestellten Stabmagneten 4, 5 auch andere Formen von Permanentmagneten eingesetzt werden. Insbesondere ist hierbei an den Einsatz kunststoffgebundener Magnete zu denken, die entsprechend einem gewünschten Muster aufmagnetisiert werden. Auf der Seite des Gehäuses 2 kann aber auch eine etwa aus Spulen und Polstücken aufgebaute Elektromagnetanordnung eingesetzt werden, deren Magnetfeldstärke durch Änderung des Spulenstroms variiert werden kann.

Bei der in der Darstellung gezeigten Anordnung der Stabmagnete 4, 5 ergibt sich in der Zwischenstellung zwischen zwei Rastpositionen eine labile Gleichgewichtsstellung in der der Drehring 3 verharren könnte. Um dies zu vermeiden, wird zumindest ein weiterer Magnet 10 mit entgegen gesetzter Polarität genau zwischen zwei der Magneten 5 auf der Gehäuseseite eingesetzt. Auch von diesen entgegengesetzt ausgerichteten Magneten 10 sind in der gezeigten Ausführungsform mehrere vorhanden. Diese bewirken zusätzlich durch die in der Zwischenstellung des Drehrings 3 zwischen zwei Rastpositionen wirksame Abstoßungskraft eine leichte Hubbewegung des Drehrings 3 innerhalb seines Lagers, was zu einer weiteren Feineinstellung der Haptik ausgenutzt werden kann.

Einer oder mehrere der weiteren Magnete 10 mit entgegen gesetzter Polarität in der Aufnahmevorrichtung 7 ist/sind im Gegensatz zu den übrigen Magneten 5 in der Aufnahmevorrichtung 7 sowie den Magneten 4 im Drehring 3, die durch Stoff- oder Formschluss jeweils in ihrer Aufnahme festgesetzt sind, in leicht übermäßigen Kammern aufgenommen, die eine Bewegung in axialer Richtung zulassen. Durch die beim Drehen des Drehrings 3 auftretenden Änderungen des am Ort dieser Magnete 10 herrschenden Feldes, werden diese in Ihren Kammern auf und ab bewegt und Erzeugen beim Anschlagen an die axialen Begrenzungswände ihrer Kammern ein Klickgeräusch, das vom Bediener als zusätzliche akustische Rückmeldung der Rastung wahrgenommen wird.

In der Aufnahmevorrichtung 7 sind in einem größeren Zwischenraum der Magnetanordnung zwei insbesondere als Hall-Sensoren ausgebildete Magnetfeldsensoren 11, 12 zur Detektion der Magnetfelder der Magnete 4 des Drehrings 3 platziert. Dies ist in Fig. 4 dargestellt, wobei die Gehäuseteile nicht gezeigt sind, sondern nur die Anordnungen der Magnete 4, 5 und die Magnetfeldsensoren 11, 12. Der Winkelabstand der beiden Magnetfeldsensoren 11, 12 zueinander ist kleiner als der Winkelabstand zweier der Magneten 4 des Drehrings 3, bevorzugt etwa die Hälfte dieses Winkelabstands. Die durch die Drehbewegung des Drehrings 3 verursachten Änderungen der am Ort der Magnetfeldsensoren 11, 12 herrschenden Magnetfeldstärken werden durch diese gemessen und von einer nachgeschalteten Elektronik zur Bestimmung der Drehrichtung, der Drehgeschwindigkeit und daraus abgeleitet des Drehwinkels des Drehrings 3 verwendet. Die so erhaltenen Informationen bilden die Eingabeinformationen für die Bedieneinrichtung. Die Drehrichtung, Drehgeschwindigkeit und der Drehwinkels des Drehrings 3 können alternativ hierzu durch berührungslos optisch oder kapazitiv arbeitende Quasi-Touch-Bildschirme der nächsten Generation auch direkt durch diese mittels einer durch die verwendete Technologie erfassbaren Strukturierung des Drehrings 3 ermittelt werden.

Das in Fig. 3 gezeigte Lager des Drehrings 3 kann in dem Gehäuse 2 selbst in einem weiteren Lager so aufgenommen sein, dass es eine Kippbewegung mit einem sehr kleinen Kippwinkel ausführen kann. Durch Ausnutzung einer solchen Kippbewegung zur Betätigung zugeordneter Schaltelemente oder Erzeugung entsprechender Signale durch den Bildschirm kann somit eine weitere Bedieneingabe durch Drücken auf den Drehring 3 vorgesehen werden.

## Patentansprüche

1. Bildschirmbasiertes Fahrzeugbediensystem mit einer zumindest einen Bildschirm (1) sowie zumindest ein gegenüber einem feststehenden Gehäuse (2) drehbeweglich gelagertes mechanisches Bedienelement umfassenden Bedieneinrichtung, wobei das mechanische Bedienelement derart angeordnet ist, dass es teilweise in das Anzeigefeld des Bildschirms (1) hineinragt und dieses dort teilweise überdeckt, **dadurch gekennzeichnet, dass** das mechanische Bedienelement als Drehring (3) ausgeführt ist, der auf einem ersten Teil (3') seines Umfangs in axialer Richtung in das Gehäuse (2) eingelassen ist und mit einem zweiten Teil (3") seines Umfangs vollständig aus dem Gehäuse (2) heraus ragt und sich mit diesem Teil (3") zumindest abschnittsweise oberhalb der Oberfläche des Bildschirms (1) erstreckt, so dass die Anzeigefläche des Bildschirms (1) im "Inneren" des Drehrings (3) für Anzeige- und/oder Bedienzwecke nutzbar ist.

2. Bildschirmbasiertes Fahrzeugbediensystem nach Anspruch 1, **dadurch gekennzeichnet, dass** in dem Drehring (3) und in dem Gehäuse (2) jeweils Mittel zur Erzeugung magnetischer Felder vorhanden sind, die miteinander zur Bildung einer Rastvorrichtung zusammenwirken.

3. Bildschirmbasiertes Fahrzeugbediensystem nach Anspruch 2, **dadurch gekennzeichnet, dass** in dem Drehring (3) eine mehrere Magnetpole ausbildende permanentmagnetische Struktur aufgenommen ist, die mit in dem Gehäuse (2) angeordneten Magnetfelderzeugungsmitteln zur Bildung einer Rastvorrichtung kooperiert.

4. Bildschirmbasiertes Fahrzeugbediensystem nach Anspruch 2, **dadurch gekennzeichnet, dass** in dem Drehring (3) eine mehrere Magnetpole ausbildende Anordnung von Permanentmagneten (4) aufgenommen ist, die mit in dem Gehäuse (2) angeordneten Magnetfelderzeugungsmitteln zur Bildung einer Rastvorrichtung kooperiert.

5. Bildschirmbasiertes Fahrzeugbediensystem nach Anspruch 3 oder 4, **dadurch gekennzeichnet, dass** die in dem Gehäuse (2) angeordneten Magnetfelderzeugungsmittel durch eine mehrere Magnetpole ausbildende Anordnung von Permanentmagneten (5) gebildet ist.

6. Bildschirmbasiertes Fahrzeugbediensystem nach Anspruch 5, **dadurch gekennzeichnet, dass** die Permanentmagneten (5) in dem Gehäuse (2) mit dem gleichen Rasterabstand, auf dem gleichen Kreisradius und in der gleichen Längsausrichtung und Polarität wie die Permanentmagneten (5) in dem Drehring (3) angeordnet sind.

7. Bildschirmbasiertes Fahrzeugbediensystem nach einem der Ansprüche 2 bis 6, **dadurch gekennzeichnet, dass** die in dem Drehring (3) vorhanden Mittel zur Erzeugung magnetischer Felder mit zumindest einem in dem Gehäuse (2) angeordneten Magnetfeldsensor (11, 12) zur Erzeugung eines Ausgangssignals kooperieren.

8. Bildschirmbasiertes Fahrzeugbediensystem nach einem der Ansprüche 1 bis 7, **dadurch gekennzeichnet, dass** der zumindest eine Bildschirm (1) Bestandteil eines mobilen Gerätes (8) ist, das in einer Aufnahmevorrichtung (7) des Gehäuses (2) aufgenommen ist.

9. Bildschirmbasiertes Fahrzeugbediensystem nach Anspruch 8, **dadurch gekennzeichnet, dass** das mobile Gerät (8) mit der Bedieneinrichtung über eine drahtlose Datenkommunikationsschnittstelle verbunden ist.

10. Bildschirmbasiertes Fahrzeugbediensystem nach Anspruch 8 oder 9, **dadurch gekennzeichnet, dass** das mobile Gerät (8) mit der Bedieneinrichtung über eine drahtlose Energieübertragungsschnittstelle verbunden ist.

## Claims

1. Screen-based vehicle operating system having a control device consisting of at least one screen (1) and at least one mechanical operating element mounted in a rotatable manner in respect of a stationary housing (2), whereby the mechanical operating element is arranged in such a fashion that it partially projects into the display field of the screen (1) where it partially conceals the same, **characterised in that** the mechanical operating element is designed as a rotating ring (3) which is inset into the housing (2) on a first portion (3') of its circumference in the axial direction and which protrudes completely out of the housing (2) with a second portion (3") of its circumference and extends with this portion (3") at least section-wise to above the surface of the screen (1) so that the display area of the screen (1) can be utilised in the "interior" of the rotating ring (3) for display and/or operating purposes.

2. Screen-based vehicle operating system according to Claim 1, **characterised in that** in both the rotating ring (3) and the housing (2) means for generating magnetic fields are provided which interact with each other for the purpose of forming a detent.

3. Screen-based vehicle operating system according to Claim 2, **characterised in that** a permanent-magnetic structure constituting a plurality of magnetic poles is accommodated in the rotating ring (3) and cooperates with the means for generating magnetic fields arranged in the housing (2) for the purpose of forming a detent.

4. Screen-based vehicle operating system according to Claim 2, **characterised in that** an arrangement of permanent magnets (4) constituting a plurality of magnetic poles is accommodated in the rotating ring (3) and cooperates with the means for generating magnetic fields arranged in the housing (2) for the purpose of forming a detent.

5. Screen-based vehicle operating system according to Claim 3 or Claim 4, **characterised in that** the means for generating magnetic fields arranged in the housing (2) are formed by an arrangement of permanent magnets (5) constituting a plurality of magnetic poles.

6. Screen-based vehicle operating system according to Claim 5, **characterised in that** the permanent magnets (5) are arranged in the housing (2) with the same grid spacing, on the same circle radius and in the same longitudinal alignment and polarity as the permanent magnets (5) in the rotating ring (3).

7. Screen-based vehicle operating system according to any of Claims 2 to 6, **characterised in that** the means for generating magnetic fields provided in the rotating ring (3) cooperate with at least one magnetic field sensor (11, 12) located in the housing (2) for the purpose of generating an output signal.

8. Screen-based vehicle operating system according to any of Claims 1 to 7, **characterised in that** the at least one screen (1) is a component of a mobile device (8) which is accommodated in a mounting fixture (7) of the housing (2).

9. Screen-based vehicle operating system according to Claim 8, **characterised in that** the mobile device (8) is connected to the control device by way of a wireless data communication interface.

10. Screen-based vehicle operating system according to Claim 8 or Claim 9, **characterised in that** the mobile device (8) is connected to the control device by way of a wireless power transmission interface.

## Revendications

1. Système de commande pour véhicule automobile, basé sur un écran, avec au moins un écran (1), ainsi qu'une installation de commande, qui comprend au moins un élément de commande mécanique, monté mobile en rotation par rapport à un boîtier (2) fixe, sachant que l'élément de commande mécanique est disposé de sorte qu'il fasse partiellement saillie dans le champ d'affichage de l'écran (1) et recouvre celui-ci partiellement, **caractérisé en ce que** l'élément de commande mécanique est réalisé en tant que bague rotative (3), qui, sur une première partie (3') de son pourtour, dans la direction axiale, est encastrée dans le boîtier (2), et qui, avec une deuxième partie (3") de son pourtour, fait saillie hors du boîtier (2) et, avec cette partie (3"), s'étend, au moins par sections, au-dessus de la surface de l'écran (1), de sorte que la surface d'affichage de l'écran (1) puisse être utilisée, à des fins d'affichage et / ou de commande, « à l'intérieur » de la bague rotative (3).

2. Système de commande pour véhicule automobile basé sur un écran selon la revendication 1, **caractérisé en ce que**, dans la bague rotative (3) et dans le boîtier (2), sont respectivement présents des moyens de génération de champs magnétiques, qui coopèrent les uns avec les autres pour former un dispositif d'arrêt.

3. Système de commande pour véhicule automobile basé sur un écran selon la revendication 2, **caractérisé en ce que**, dans la bague rotative (3), est logée une structure magnétique en permanence, formant plusieurs pôles magnétiques, laquelle coopère avec des moyens de génération de champs magnétiques, disposés dans le boîtier (2), pour former un dispositif d'arrêt.

4. Système de commande pour véhicule automobile basé sur un écran selon la revendication 2, **caractérisé en ce que**, dans la bague rotative (3), est logé un agencement d'aimants permanents (4), formant plusieurs pôles magnétiques, lequel coopère avec des moyens de génération de champs magnétiques, disposés dans le boîtier (2), pour former un dispositif d'arrêt.

5. Système de commande pour véhicule automobile basé sur un écran selon revendication 3 ou 4, **caractérisé en ce que** les moyens de génération de champs magnétiques, disposés dans le boîtier (2), sont formés par un agencement d'aimants permanents (5), formant plusieurs pôles magnétiques.

6. Système de commande pour véhicule automobile basé sur un écran selon la revendication 5, **caractérisé en ce que** les aimants permanents (5) sont disposés dans le boîtier (2) avec la même distance de balayage, sur le même rayon et dans la même direction longitudinale et avec la même polarité que les aimants permanents (5), logés dans la bague rotative (3).

7. Système de commande pour véhicule automobile basé sur un écran selon l'une des revendications 2 à 6, **caractérisé en ce que** les moyens de génération de champs magnétiques, prévus dans la bague rotative (3), coopèrent avec au moins un capteur magnétique (11, 12), disposé dans le boîtier (2), pour générer un signal de sortie.

8. Système de commande pour véhicule automobile basé sur un écran selon l'une des revendications 1 à 7, **caractérisé en ce que** l'écran (1) au moins prévu fait partie d'un appareil mobile (8), qui est logé dans un réceptacle (7) du boîtier (2).

9. Système de commande pour véhicule automobile basé sur un écran selon la revendication 8, **caractérisé en ce que** l'appareil mobile (8) est relié à l'installation de commande par l'intermédiaire d'une interface de communication de données sans fil.

10. Système de commande pour véhicule automobile basé sur un écran selon revendication 8 ou 9, **caractérisé en ce que** l'appareil mobile (8) est relié à l'installation de commande par l'intermédiaire d'une interface de transmission d'énergie sans fil.
